# EUROPÄISCHE PATENTSCHRIFT

(11) **EP 2 156 144 B1**
(45) Veröffentlichungstag und Bekanntmachung des Hinweises auf die Patenterteilung: **06.12.2017**
(21) Anmeldenummer: 08758133.6
(22) Anmeldetag: 30.05.2008
(51) Int. Cl.: G01D 11/24, B60R 11/02, H05K 5/00, B60R 11/00

(54) **STEUERGERÄT FÜR EIN KRAFTFAHRZEUG**
CONTROL DEVICE FOR A MOTOR VEHICLE
APPAREIL DE COMMANDE POUR VEHICULE AUTOMOBILE

(30) Priorität: 01.06.2007 DE 102007025859
(43) Veröffentlichungstag der Anmeldung: 24.02.2010
(73) Patentinhaber: Conti Temic Microelectronic GmbH, 90411 Nürnberg (DE)
(72) Erfinder: BÜYÜKBAS, Turhan, 95158 Kirchenlamitz (DE); KARRER, Helmut, 90762 Fürth (DE); RIETSCH, Jürgen, 95030 Hof (DE); HENNIGER, Jürgen, 91056 Erlangen (DE); GRAMANN, Matthias, 77871 Renchen (DE); WIECZOREK, Matthias, 91233 Neunkirchen a. Sand (DE); SCHARRER, Klaus, 91224 Hohenstadt (DE); GUTH, Peter, 90419 Nürnberg (DE)
(74) Vertreter: Bonn, Roman Klemens
(86) Internationale Anmeldenummer: PCT/DE2008/000893
(87) Internationale Veröffentlichungsnummer: WO 2008/145107

(56) Entgegenhaltungen:
- DE-A1-102004 034 002
- DE-A1-102005 021 717
- DE-A1-102005 040 169

## Beschreibung

Die Erfindung betrifft ein Steuergerät für ein Kraftfahrzeug gemäß dem Oberbegriff des Anspruchs 1.

In Kraftfahrzeugen werden Steuergeräte mit einer elektronischen Steuereinheit und zugeordneten Komponenten wie Sensoren für unterschiedliche Aufgaben eingesetzt. Beispielsweise werden bei einem Einsatz in einem Getriebe mittels Sensoren Drehzahlen von Wellen und Positionen von Gangstellern sensiert. Anhand dieser Informationen steuert die elektronische Steuereinheit unter anderem die Schaltvorgänge m Getriebe. Die elektronische Steuereinheit ist in der Regel auf einer Trägerplatte angeordnet und von einem Gehäusekörper umschlossen. Die Sensoren sind anwendungsbedingt von der elektronischen Steuereinheit getrennt unmittelbar in der Nähe der zu sensierenden Teile positioniert und über elektrische Leiter, insbesondere Stanzgitter mit der elektronische Steuereinheit elektrisch verbunden. Die Stanzgitter sind üblicherweise mit Kunststoff umspritzt und bilden mit dem Sensor als elektrischer Komponente und einer Sensorabdeckung einen Komponententräger, auch Sensordom genannt.

Bei Verwendung von mehreren Komponententrägern werden diese insbesondere in einem Umspritzungsprozess zu einem einzigen Monolith gesamtumspritzt . Dieser Monolith ist in der Regel ein Teil des die elektronische Steuereinheit umschließenden Gehäusekörpers, welcher mit der Trägerplatte vorzugsweise durch Verschrauben, Verstemmen oder Vernieten verbunden ist. Der Sensor ist somit über das Stanzgitter im Komponententräger und eine insbesondere einen auf die Trägerplatte auflaminierten flexiblen Folienleiter mit der elektronischen Steuereinheit auf der Trägerplatte elektrisch verbindbar.

Das Steuergerät kann nach der Fertigstellung mit einer Systemschnittstelle wie einem Getriebe oder einer Hydraulik verbunden werden. Die Toleranzketten bei der Positionierung des Sensors zum zu sensierenden Teil mit der Verbindung des Steuergeräts mit der Systemschnittstelle als Referenzpunkt sind einerseits insbesondere abhängig von den Werkzeugparametern bei der Herstellung des Monoliths und von den Schwindungsprozessen nach der Gesamtumspritzung. Bei der Verbindung des Monoliths bzw. des Gehäusekörpers mit der Trägerplatte kann eine weitere Toleranzkette entstehen. Sich eventuell anschließende Ofenprozesse können zusätzliche Ungenauigkeiten in der Positionierung des Sensors beitragen.

Die DE 10 2005 040 169 A1 beschreibt eine Trägerplatte für Steuermodule, insbesondere für Getriebesteuermodule für Kraftfahrzeuge, mit mindestens einem Sensordom, in welchem ein Sensor montiert ist, wobei der Sensor eine Mantelflache mit rillenförmig angebrachten Erhebungen und Stanzgitter umfasst, die in einer freien Lange ausgeführt sind, welche ein maximales Einbaumaß des Sensors in Bezug auf die Oberseite der Trägerplatte übersteigt.

Die DE 10 2005 021 717 A1 beschreibt eine Sensoranordnung für einen Drehzahlsensor eines Automatikgetriebes eines Kraftfahrzeugs, wobei sie einen Modulträger umfasst, in dem ein Teil des Sensorgehäuses angeordnet ist, wobei das Sensorgehäuse im Modulträger oder im Getriebegehäuse mittels einer Führung in der Ebene fixiert und gegen Verdrehen gesichert ist, und dass sie eine Einrichtung zum Erzeugen einer Vorspannkraft umfasst, durch die das Sensorgehäuse in Richtung auf das Geberrad über einen am Sensorgehäuse gebildeten Absatz gegen einen Anschlag gedrückt wird.

Es ist daher die Aufgabe der Erfindung, ein Steuergerät für Kraftfahrzeuge gemäß dem Oberbegriff des Anspruchs 1 anzugeben, das die Toleranzketten bei der Positionierung einer elektronischen Komponente, wie einem Sensor, bei gleichzeitig vereinfachtem Handling, zu einem zu sensierenden Teil reduziert.

Diese Aufgabe wird erfindungsgemäß durch ein Steuergerät mit den Merkmalen des Oberbegriffs des Anspruchs 1 durch die Merkmale des kennzeichnenden Teils des Anspruchs 1 gelöst.

Die Trägerplatte des Steuergeräts weist eine Ausnehmung zur Aufnahme des Komponententrägerfußes auf. Dabei entsprechen die Abmessungen der Ausnehmung im Bereich des Komponententrägerfußes in X/Y-Richtung den maximalen Abmessungen des Komponententrägerfußes (5) in X/Y-Richtung.

Die Trägerplatte weist eine teilweise durchgehende Ausnehmung auf, durch die der Komponententräger durchführbar ist und die ferner zur Aufnahme des Komponententrägerfußes geeignet ist. Die Abmessungen der Ausnehmung in X/Y-Richtung im Bereich des Komponententrägers und im Bereich des Komponententrägerfußes entsprechen den maximal zulässigen Abmessungen des Komponententrägers und des Komponententrägerfußes in X/Y-Richtung. In Z-Richtung ist an der Ausnehmung der Trägerplatte oder am Komponententrägerfuß wenigstens eine Verpressgeometrie derart angeordnet, dass nach formschlüssiger oder kraftschlüssiger Anbindung der Trägerplatte an eine Systemschnittstelle, wie einem Getriebe oder einer Hydraulik, die Verpressgeometrie oder das an der Verpressgeometrie anliegende Teil derart verformt ist, dass der Komponententrägerfuß spielfrei in der Ausnehmung fixiert ist. Der Vorteil dieser modularen Anordnung von Komponententrägern an der Trägerplatte ist, dass bei mehreren Komponententrägern vor allem die Toleranzkette durch die Gesamtumspritzung zu einem einzigen Monolith entfällt. Die einzigen verbleibenden Toleranzketten werden verursacht durch die Position der elektronischen Komponente im Komponententräger selbst und durch die Positionierung des Steuergeräts an die Systemschnittstelle.

Das erfindungsgemäße Steuergerät vereinfacht das Handling sowohl bei der Anordnung des Komponententrägers an der Trägerplatte als auch bei der Anbindung der Trägerplatte an der Systemschnittstelle, da die endgültige Positionierung des Komponententrägers und somit der elektronischen Komponente zum zu sensierenden Teil erst in diesem letzten Schritt geschieht.

Ein Steuergerät gemäß den Ansprüchen 2 bis 4 ermöglicht eine Vielfalt der Ausgestaltung der Verpressgeometrie in Bezug auf Material und Art der Anbringung und reduziert vor allem Toleranzkette in Z-Richtung.

Ein Steuergerät gemäß Anspruch 5 ermöglicht es, dass die elektrische Verbindung der elektronischen Komponente in der Sensortasche des Komponententrägers mit der elektronischen Steuerschaltung auf der Trägerplatte vor der endgültigen Positionierung des Komponententrägers herstellbar ist.

Ein Steuergerät gemäß Anspruch 6 stellt eine einfache Möglichkeit dar, den Komponententräger in X/Y-Richtung zu positionieren.

Ein Steuergerät gemäß Anspruch 7 führt zu einer Klemmung des Zentrierzapfens des Komponententrägers in der Bohrung der Systemschnittstelle, wobei diese Klemmung und damit die Positionierung in X/Y-Richtung insbesondere auch bei Schwankungen der Umgebungstemperatur des Komponententrägers erhalten bleibt.

Ein Steuergerät gemäß Anspruch 8 ermöglicht eine einfache und kostengünstige Anbindung der Trägerplatte und damit des Steuergeräts an die Systemschnittstelle.

Weitere Vorteile und Merkmale der Erfindung ergeben sich aus der nachfolgenden Beschreibung eines Ausführungsbeispiels der Erfindung anhand der Zeichnungen. Es zeigen:
- Fig.1: ein Steuergerät vor der Anbindung an eine Systemschnittstelle und
- Fig.2: einen Zentrierzapfen mit zwei Klemmrippen in einer Bohrung im Querschnitt.

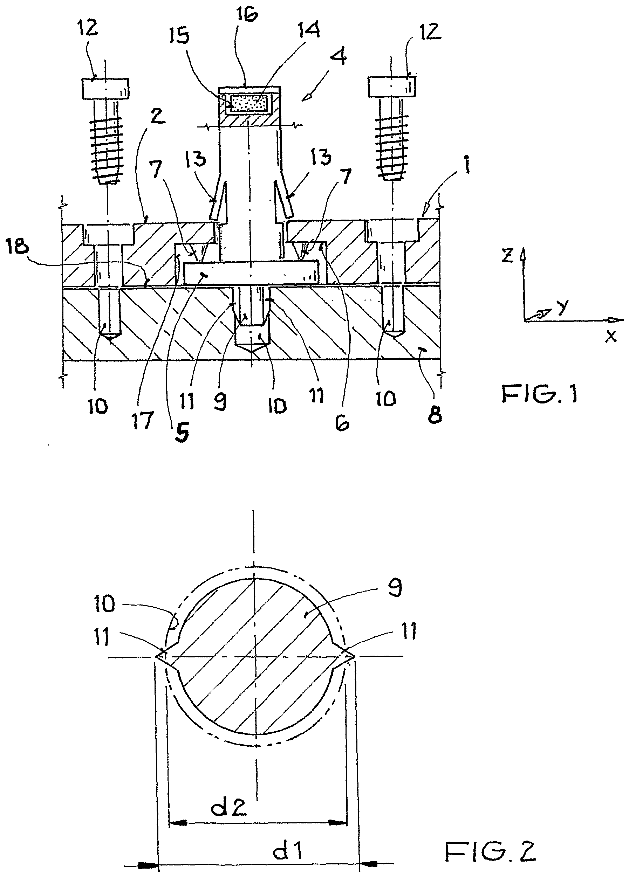

Fig. 1 zeigt eine Trägerplatte 1 eines Steuergeräts mit einem Komponententräger 4 vor der Anbindung an eine Systemschnittstelle 8 mittels Verschrauben durch die Schrauben 12. Der Komponententräger 4 weist an einem Ende eine Sensortasche 15 zur Aufnahme einer elektronischen Komponente, in diesem Fall eines Sensors 14, auf. Eine Abdeckung 16 schließt die Sensortasche 15 ab. Insbesondere sind der Sensor 14 und die Sensortasche 15 so dimensioniert, dass die Abdeckung 16 im montierten Zustand den Sensor 14 mit einer gewissen Vorspannung in der Sensortasche 15 fixiert. Der Komponententräger 4 weist an dem anderen Ende einen Komponententrägerfuß 5 auf, dessen Querschnitt zumindest teilweise größer ist als der Querschnitt des eigentlichen Komponententrägers 4 selbst. Beispielsweise ist bei einem zylinderförmigen Komponententräger 4 der Durchmesser des Komponententrägerfußes 5 größer als der Durchmesser des eigentlichen Komponententrägers 4. Denkbar wäre auch ein rechteckiger Querschnitt. Denkbar wäre auch, dass der Komponententrägerfuß 5 in Form von beispielsweise zwei Auslegern am Ende des Komponententrägers 4 im rechten Winkel herausragen.

Die Ausnehmung 6 der Trägerplatte 1 ist als durchgehende Bohrung mit zwei verschiedenen Querschnitten ausgestaltet. Der Querschnitt an der Oberseite 2 der Trägerplatte 1 entspricht dem Nominalmaß des Querschnitts des eigentlichen Komponententrägers 4 plus dem größt möglichen Toleranzmaß. Der Querschnitt an der Unterseite 2 der Trägerplatte 1 entspricht dem Nominalmaß des Querschnitts des Komponententrägerfußes 5 plus dem größt möglichen Toleranzmaß. Weichen die jeweiligen größt möglichen Toleranzmaße der beiden Querschnitte voneinander ab, so wird das größere von beiden verwendet.

An der Außenseite des Komponententrägers 4 sind zwei Rastnasen 13 so angeordnet, dass beim Einführen des Komponententrägers 4 in die Ausnehmung 6 die Rastnasen 13 nach dem Passieren der Oberseite 2 der Trägerplatte 1 der Komponententräger 4 so verrastet ist, dass der Komponententräger 4 in der Trägerplatte 1 in X/Y/Z-Richtung noch Spiel aufweist. Die Anzahl der Rastnasen 13 kann auch von zwei verschieden sein.

In der Ausnehmung 6 ist an der Unterseite 3 der metallischen Trägerplatte 1 eine aus der Unterseite 3 herausragende Verpressgeometrie 7 einstückig mit der Trägerplatte 1 ausgeformt. Alternativ dazu kann die Verpressgeometrie 7 auch an die Unterseite 3 der Trägerplatte 1 im entsprechenden Bereich der Ausnehmung 6 aus Kunststoff angespritzt sein. Denkbar wäre auch, dass eine aus Kunststoff hergestellte Verpressgeometrie 7 am Komponententrägerfuß 5 an dessen Oberseite 2 oder Unterseite 3 angeordnet sein. Insbesondere kann in diesem Fall die Verpressgeometrie 7 und der Komponententrägerfuß 5 aus einem Stück bestehen Die Summe aus den Abmessungen der Verpressgeometrie 7 und des Komponententrägerfußes 5 jeweils in Z-Richtung ist insbesondere größer als die Tiefe 17 (ebenfalls in Z-Richtung) der Ausnehmung 6 im Bereich mit dem größeren Querschnitt. Bei der Montage der Trägerplatte 1 an die Systemschnittstelle 8 wird die Verpressgeometrie 7, falls sie aus Kunststoff ist, verformt. Falls sie aber ein Teil der metallischen Trägerplatte 1 ist, wird bei der Montage der Trägerplatte 1 an die Systemschnittstelle 8 das der Verpressgeometrie 7 gegenüberliegende Teil, also der aus Kunststoff bestehende Komponententrägerfuß 5 verformt. In jedem Fall wird bei der Montage der Komponententräger 4 im Bereich des Komponententrägerfußes 5 gegen die Anlagefläche 18 der Systemschnittstelle 8 gepresst und somit fixiert. Die Verpressgeometrie 7 kann punktförmig, teilweise oder ganz die Ausnehmung 6 oder den Komponententrägerfuß 5 umlaufend, zum Beispiel als Wulst, ausgeführt sein.

Wie in der Fig. 1 gezeigt, weist die Unterseite des Komponententrägerfußes 5 einen zylinderförmigen Zentrierzapfen 9 auf, der im rechten Winkel absteht. In diesem Fall ist der Zentrierzapfen 9 mittig an der Unterseite des Komponententrägerfußes 5 angeordnet. Es können aber auch mehrere Zentrierzapfen 9 verwendet werden, die gleichmäßig oder auch willkürlich über die Unterseite des Komponententrägerfußes 5 verteilt sind.

Der Zentrierzapfen 9 weist insbesondere umlaufend gleichmäßig verteilt wenigstens zwei parallel zur Achse des Zentrierzapfens 9 verlaufende Klemmrippen 11 auf. Bei der Montage der Trägerplatte 1 an die Systemschnittstelle 8 wird der Zentrierzapfen 9 in eine entsprechende Bohrung 10 in der Systemschnittstelle 8 eingebracht. Wie in Fig. 2 gezeigt, ist der Durchmesser des Zentrierzapfens 9 im Bereich der Klemmrippen 11 geringfügig größer als der Durchmesser der entsprechenden Bohrung 10 in der Systemschnittstelle 8. Dadurch ist der Zentrierzapfen 9 nach der Montage in die Bohrung 10 der Systemschnittestelle 8 eingepresst und der Komponententräger 4 und somit der Sensor 14 in X/Y-Richtung positioniert. Die Abmessung des Zentrierzapfens 9 in Z-Richtung muss geringer sein als die Tiefe der Bohrung 10, um sicherzustellen, dass die Positionierung des Sensors 14 in Z-Richtung durch den Zentrierzapfen 9 nicht beeinflusst wird.

Zur X/Y-Positionierung des Sensors 14 muss der Komponententrägerfuß 5 nicht zwangsläufig einen Zentrierzapfen 9 aufweisen. Es wäre auch durchaus denkbar, dass der Komponententräger 4 bei der Montage der Trägerplatte 1 an die Systemschnittstelle 8 mit einer seiner Außenflächen an einen X/Y-Referenzpunkt außerhalb des Steuergeräts und der Systemschnittstelle 8 in der Nähe des zu sensierenden Teils angelegt wird.

In Fig. 1 wird gezeigt, dass die Trägerplatte 1 mit der Systemschnittstelle 8 mittels der Schrauben 12 verschraubt wird. Alternativ könnte die Anbindung auch durch beispielsweise durch Verstemmen oder Vernieten hergestellt werden.

Das beschriebene Steuergerät ermöglicht es, dass bei der Positionierung in X/Y/Z-Richtung einer elektronischen Komponente, insbesondere eines Sensors 14, zu einem zu sensierenden Teil die Toleranzketten auf den Komponententräger 4 und die Systemschnittstelle 8 reduziert werden.

Die vorliegende Erfindung wurde anhand der vorstehenden Beschreibung so dargestellt, um das Prinzip der Erfindung und dessen praktische Anwendung bestmöglich zu erklären. Jedoch lässt sich die Erfindung bei geeigneter Abwandlung selbstverständlich in anderen, in den abhängigen Ansprüchen beschriebenen Ausführungsformen realisieren.

### Bezugszeichenliste:

- **1**: Trägerplatte
- **2**: Oberseite der Trägerplatte
- **3**: Unterseite der Trägerplatte
- **4**: Komponententräger
- **5**: Komponententrägerfuß
- **6**: Ausnehmung in der Trägerplatte
- **7**: Verpressgeometrie
- **8**: Systemschnittstelle
- **9**: Zentrierzapfen
- **10**: Bohrung in der Systemschnittstelle
- **11**: Klemmrippe
- **12**: Schraube
- **13**: Rastnase an Komponententräger
- **14**: Elektronische Komponente/Sensor
- **15**: Sensortasche
- **16**: Abdeckung der Sensortasche
- **17**: Tiefe der Ausnehmung im Bereich mit dem größeren Querschnitt
- **18**: Anlagefläche der Systemschnittstelle
- **d1**: Durchmesser des Zentrierzapfens plus Klemmrippen
- **d2**: Durchmesser der Bohrung in der Systemschnittstelle zur Aufnahme des Zentrierzapfens

## Patentansprüche

1. Steuergerät für ein Kraftfahrzeug, umfassend eine metallische Trägerplatte (1), mit einer Oberseite (2) und einer Unterseite (3), zur Aufnahme einer elektronischen Steuerschaltung, und mit mindestens einem Komponententräger (4) aus Kunststoff mit einem Komponententrägerfuß (5), wobei die Trägerplatte (1) wenigstens in Z-Richtung und der Komponententrägerfuß (5) in X/Y/Z-Richtung mit Abmessungstoleranzen behaftet sind, wobei die Trägerplatte (1) eine teilweise durchgehende Ausnehmung (6) aufweist, durch die der Komponententräger (4) durchführbar ist und die ferner zur Aufnahme des Komponententrägerfußes (5) geeignet ist, wobei die Tiefe der Ausnehmung (6) in Z-Richtung ausgebildet ist, wobei die Abmessungen der Ausnehmung (6) im Bereich des Komponententrägers (4) und im Bereich des Komponententrägerfußes (5) in X/Y-Richtung den maximal zulässigen Abmessungen des Komponententrägers (4) und des Komponententrägerfußes (5) in X/Y-Richtung entsprechen und wobei an der Ausnehmung (6) der Trägerplatte (1) oder am Komponententrägerfuß (5) jeweils in Z-Richtung wenigstens eine Verpressgeometrie (7) derart angeordnet ist, dass nach formschlüssiger oder kraftschlüssiger Anbindung der Trägerplatte (1) an eine Systemschnittstelle (8), wie einem Getriebe oder einer Hydraulik, die Verpressgeometrie (7) oder das der Verpressgeometrie (7) gegenüberliegende Teil derart verformt ist, dass der Komponententrägerfuß (5) spielfrei in der Ausnehmung (6) fixiert ist, **dadurch gekennzeichnet, dass**
der Komponententräger (4) vor dem Anbinden der Trägerplatte (1) an die Systemschnittstelle (8) im Bereich des Komponententrägerfuß (5) mit der Trägerpatte (1) in der Ausnehmung (6) spielbehaftet verrastet ist.

2. Steuergerät nach Anspruch 1 **dadurch gekennzeichnet, dass** die Verpressgeometrie (7) aus Kunststoff hergestellt ist und am Komponententrägerfuß (5) oder an der Ausnehmung (6) der metallischen Trägerplatte (1) angeordnet ist und dass nach der Anbindung der Trägerplatte (1) an die Systemschnittstelle (8) die Verpressgeometrie (7) verformt ist.

3. Steuergerät nach Anspruch 1 **dadurch gekennzeichnet, dass** die Verpressgeometrie (7) ein Teil der Ausnehmung (6) der metallischen Trägerplatte (1) ist und dass nach der Anbindung der Trägerplatte (1) an die Systemschnittstelle (8) der der Verpressgeometrie (7) gegenüberliegende Teil des Komponententrägerfußes (5) verformt ist.

4. Steuergerät nach einem der vorhergehenden Ansprüche, **dadurch gekennzeichnet, dass** die Verpressgeometrie (7) am Komponententrägerfuß (5) oder an der Ausnehmung (6) der Trägerplatte (1) punktförmig oder in X/Y-Richtung ganz oder teilweise umlaufend und im wesentlichen in Z-Richtung verformbar angeordnet ist.

5. Steuergerät nach einem der vorhergehenden Ansprüche, **dadurch gekennzeichnet, dass** der Komponententräger (4) auf dem dem Komponententrägerfuß (5) gegenüberliegenden Ende wenigstens eine elektronische Komponente (14) in einer Sensortasche (15) aufnimmt und diese Komponente (14) über im Komponententräger (4) integrierte elektrische Leiter und wenigstens eine auf der Trägerplatte (1) angeordnete flexible Leiterfolie mit der elektronischen Steuerschaltung verbindbar ist.

6. Steuergerät nach einem der vorhergehenden Ansprüche, **dadurch gekennzeichnet, dass** der Komponententrägerfuß (5) an seiner Unterseite wenigstens einen Zentrierzapfen (9) aufweist, der beim Anbinden der Trägerplatte (1) an die Systemschnittstelle (8) in eine entsprechende Bohrung (10) in der Systemschnittstelle (8) kraftschlüssig einbringbar ist.

7. Steuergerät nach Anspruch 6 7, **dadurch gekennzeichnet, dass** der Zentrierzapfen (9) umlaufend gleichmäßig verteilt wenigstens zwei parallel zur Achse des Zentrierzapfens (9) verlaufende Klemmrippen (11) aufweist, wobei der Durchmesser des Zentrierzapfens (9) mit den Klemmrippen (11) geringfügig größer ist als der Durchmesser der entsprechenden Bohrung (10) in der Systemschnittstelle (8).

8. Steuergerät nach einem der vorhergehenden Ansprüche, **dadurch gekennzeichnet, dass** die Trägerplatte (1) mittels Verschrauben, Verstemmen oder Vernieten an die Systemschnittstelle (8) anbindbar ist.

## Claims

1. Control device for a motor vehicle, comprising a metal carrier plate (1), having a top side (2) and a bottom side (3), for receiving an electronic control circuit, and having at least one component carrier (4) which is composed of plastic and has a component carrier foot (5), wherein the carrier plate (1) is subject to dimensional tolerances at least in the Z-direction and the component carrier foot (5) is subject to dimensional tolerances in the X/Y/Z-direction, wherein the carrier plate (1) has a partially continuous recess (6) through which the component carrier (4) can be passed and which is further suitable for receiving the component carrier foot (5), wherein the depth of the recess (6) is formed in the Z-direction, wherein the dimensions of the recess (6) in the region of the component carrier (4) and in the region of the component carrier foot (5) in the X/Y-direction correspond to the maximum permissible dimensions of the component carrier (4) and of the component carrier foot (5) in the X/Y-direction, and wherein at least one pressing geometry (7) is arranged on the recess (6) of the carrier plate (1) or on the component carrier foot (5) in each case in the Z-direction in such a way that, after interlocking or force-fitting connection of the carrier plate (1) to a system interface (8), such as a gear mechanism or a hydraulics system, the pressing geometry (7) or the part which is situated opposite the pressing geometry (7) is deformed in such a way that the component carrier foot (5) is fixed in the recess (6) without play, **characterized in that** the component carrier (4), before the connection of the carrier plate (1) to the system interface (8), is latched to the carrier plate (1) in the recess (6) with play in the region of the component carrier foot (5).

2. Control device according to Claim 1, **characterized in that** the pressing geometry (7) is produced from plastic and is arranged on the component carrier foot (5) or on the recess (6) of the metal carrier plate (1), and **in that**, after the connection of the carrier plate (1) to the system interface (8), the pressing geometry (7) is deformed.

3. Control device according to Claim 1, **characterized in that** the pressing geometry (7) is a part of the recess (6) of the metal carrier plate (1), and **in that**, after the connection of the carrier plate (1) to the system interface (8), that part of the component carrier foot (5) which is situated opposite the pressing geometry (7) is deformed.

4. Control device according to one of the preceding claims, **characterized in that** the pressing geometry (7) is arranged on the component carrier foot (5) or on the recess (6) of the carrier plate (1) at points or entirely or partially circumferentially in the X/Y-direction and such that it can be deformed substantially in the Z-direction.

5. Control device according to one of the preceding claims, **characterized in that** the component carrier (4), on the end which is situated opposite the component carrier foot (5), receives at least one electronic component (14) in a sensor pocket (15), and this component (14) can be connected to the electronic control circuit by means of electrical conductors which are integrated in the component carrier (4) and at least one flexible conductor foil which is arranged on the carrier plate (1).

6. Control device according to one of the preceding claims, **characterized in that** the component carrier foot (5) has at least one centring pin (9) on its bottom side, it being possible for the at least one centring pin to be inserted in a force-fitting manner into a corresponding bore (10) in the system interface (8) when the carrier plate (1) is connected to the system interface (8).

7. Control device according to Claim 6, **characterized in that** the centring pin (9) has, in a manner distributed circumferentially uniformly, at least two clamping ribs (11) which run parallel to the axis of the centring pin (9), wherein the diameter of the centring pin (9) with the clamping ribs (11) is slightly larger than the diameter of the corresponding bore (10) in the system interface (8).

8. Control device according to one of the preceding claims, **characterized in that** the carrier plate (1) can be connected to the system interface (8) by means of screwing, caulking or riveting.

## Revendications

1. Contrôleur pour un véhicule automobile, comprenant une plaque porteuse (1) métallique ayant un côté supérieur (2) et un côté inférieur (3), destinée à accueillir un circuit de commande électronique, et comprenant au moins un support de composant (4) en matière plastique ayant un pied de support de composant (5), la plaque porteuse (1) étant soumise à des tolérances dimensionnelles au moins dans la direction Z et le pied de support de composant (5) dans la direction X/Y/Z, la plaque porteuse (1) possédant une cavité (6) partiellement traversante à travers laquelle peut être passé le support de composant (4) et étant en outre adaptée pour accueillir le pied de support de composant (5), la profondeur de la cavité (6) étant formée dans la direction Z, les dimensions de la cavité (6) dans la zone du support de composant (4) et dans la zone du pied de support de composant (5) dans la direction X/Y correspondant aux dimensions maximales admissibles du support de composant (4) et du pied de support de composant (5) dans la direction X/Y et au moins une forme géométrique de pressage (7) étant disposée au niveau de la cavité (6) de la plaque porteuse (1) ou au niveau du pied de support de composant (5), respectivement dans la direction Z, de telle sorte qu'après un rattachement par complémentarité de formes ou par force de la plaque porteuse (1) au niveau d'une interface de système (8), comme un engrenage ou un système hydraulique, la forme géométrique de pressage (7) ou la partie à l'opposé de la forme géométrique de pressage (7) est déformée de telle sorte que le pied de support de composant (5) est immobilisé sans jeu dans la cavité (6), **caractérisé en ce que** le support de composant (4), avant le rattachement de la plaque porteuse (1) à l'interface de système (8) est enclenché avec un jeu dans la cavité (6) dans la zone du pied de support de composant (5) avec la plaque porteuse (1).

2. Contrôleur selon la revendication 1, **caractérisé en ce que** la forme géométrique de pressage (7) est fabriquée en matière plastique et elle est disposée sur le pied de support de composant (5) ou au niveau de la cavité (6) de la plaque porteuse (1) métallique et **en ce que** la forme géométrique de pressage (7) est déformée après le rattachement de la plaque porteuse (1) à l'interface de système (8).

3. Contrôleur selon la revendication 1, **caractérisé en ce que** la forme géométrique de pressage (7) est une partie de la cavité (6) de la plaque porteuse (1) métallique et **en ce que** la partie du pied de support de composant (5) à l'opposé de la forme géométrique de pressage (7) est déformée après le rattachement de la plaque porteuse (1) à l'interface de système (8) .

4. Contrôleur selon l'une des revendications précédentes, **caractérisé en ce que** la forme géométrique de pressage (7) est disposée au niveau du pied de support de composant (5) ou au niveau de la cavité (6) de la plaque porteuse (1) de manière à pouvoir être déformée ponctuellement, ou entièrement ou partiellement de manière circonférentielle dans la direction X/Y, et sensiblement dans la direction Z.

5. Contrôleur selon l'une des revendications précédentes, **caractérisé en ce que** le support de composant (4) accueille, sur l'extrémité à l'opposé du pied de support de composant (5), au moins un composant électronique (14) dans une poche de capteur (15) et ce composant (14) peut être relié au circuit de commande électronique par le biais de conducteurs électriques intégrés dans le support de composant (4) et au moins un film conducteur souple disposé sur la plaque porteuse (1).

6. Contrôleur selon l'une des revendications précédentes, **caractérisé en ce que** le pied de support de composant (5) possède sur son côté inférieur au moins un tenon de centrage (9) qui, lors du rattachement de la plaque porteuse (1) à l'interface de système (8), peut être introduit dans un orifice (10) correspondant dans l'interface de système (8).

7. Contrôleur selon la revendication 6 7, **caractérisé en ce que** le tenon de centrage (9) possède au moins deux nervures de serrage (11), distribuées de manière homogène sur le pourtour et s'étendant parallèlement à l'axe du tenon de centrage (9), le diamètre du tenon de centrage (9) pourvu des nervures de serrage (11) étant légèrement supérieur au diamètre de l'orifice (10) correspondant dans l'interface de système (8) .

8. Contrôleur selon l'une des revendications précédentes, **caractérisé en ce que** la plaque porteuse (1) peut être rattachée à l'interface de système (8) par vissage, matage ou rivetage.
